# EUROPEAN PATENT SPECIFICATION

(11) **EP 1 182 504 B1**
(45) Date of publication and mention of the grant of the patent: **14.12.2005**
(21) Application number: 01306996.8
(22) Date of filing: 17.08.2001
(51) Int. Cl.: G03F 1/00, G03F 1/08

(54) **Phase shift mask blank, phase shift mask, and methods of manufacture**
Phasenschiebermaske, Rohling sowie Verfahren zu deren Herstellung
Masque à décalage de phase, son précurseur et procédé pour sa fabrication

(30) Priority: 21.08.2000 JP 2000249174
(43) Date of publication of application: 27.02.2002
(73) Proprietor: Shin-Etsu Chemical Co., Ltd., Chiyoda-ku, Tokyo (JP)
(72) Inventor: Inazuki, Yukio c/o Shin Etsu Chemical Co., Ltd., Nakakubiki-gun Niigata-ken (JP); Maruyama, Tamotsu c/o Shin Etsu Chemical Co., Ltd., Nakakubiki, Niigata-ken (JP); Kaneko, Hideo c/o Shin Etsu Chemical Co., Ltd., Nakakubiki, Niigata-ken (JP); Okazaki, Satoshi c/o Shin Etsu Chemical Co., Ltd., Nakakubiki, Niigata-ken (JP)
(74) Representative: Stoner, Gerard Patrick

(56) References cited:
- US-A- 5 804 337
- US-A- 5 952 128
- PATENT ABSTRACTS OF JAPAN vol. 1997, no. 08, 29 August 1997 (1997-08-29) & JP 09 096898 A (HOYA CORP), 8 April 1997 (1997-04-08)

## Description

### BACKGROUND

The present invention relates to phase shift mask blanks and phase shift masks e.g. suitable for use in photolithography associated with the microfabrication of electronic products such as semiconductor integrated circuits, charge-coupled devices, color filters for liquid-crystal displays, and magnetic heads. The invention relates also to methods of manufacturing such phase shift mask blanks and phase shift masks.

The invention relates most particularly to halftone phase shift mask blanks and phase shift masks which can attenuate the intensity of exposure wavelength light with a phase shift film, and to methods of manufacturing such phase shift mask blanks and phase shift masks.

The photomasks that are used in a broad range of applications, including the manufacture of semiconductor integrated circuit (IC) and large-scale integration (LSI) chips, are basically composed of a transparent substrate on which a light-shielding layer made primarily of chromium has been formed in a given pattern. The market demand for ever higher levels of integration in semiconductor integrated circuits has led to a rapid reduction in the minimum feature size of photomask patterns. Such miniaturization has been achieved in part by the use of exposure light of shorter wavelengths.

However, while exposure using shorter wavelength light does improve resolution, it also has a number of undesirable effects, such as reducing the focal depth, lowering process stability and adversely impacting product yield.

One pattern transfer technique that has been effective for resolving such problems is phase shifting. This involves the use of a phase shift mask as the mask for transferring microscopic circuit patterns.

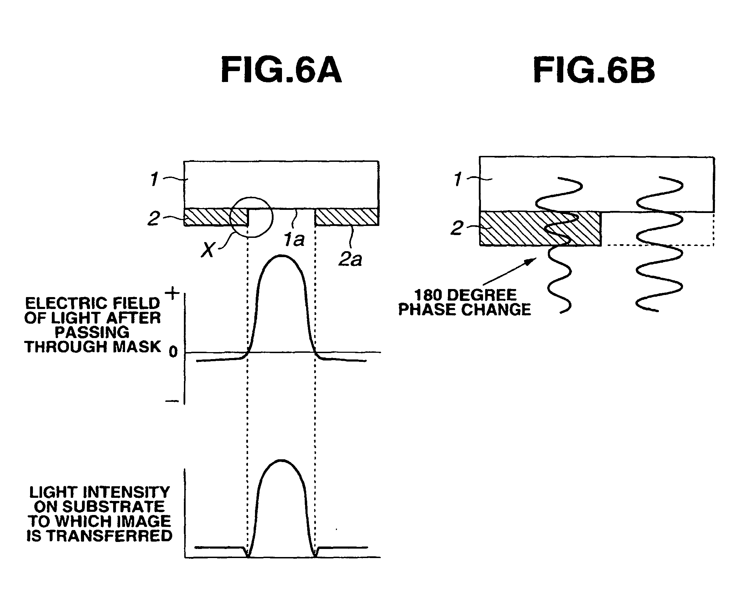

As shown in accompanying FIGS. 6A and 6B, a phase shift mask (halftone phase shift mask) typically has a phase shifter 2a that forms a pattern area on the mask and an exposed substrate area 1a without phase shifter 2a where the substrate lies exposed to incident light. The phase shift mask improves contrast of the transferred image by providing, as shown in FIG. 6B, a phase difference of 180 degrees between light passing through the pattern and non-pattern areas, and utilizing the destructive interference of light at the boundary regions of the pattern to set the light intensity in the areas of interference to zero. The use of phase shifting also makes it possible to increase the focal depth at the necessary resolution. Hence, compared with a conventional mask having an ordinary exposure pattern, such as one composed of chromium film, a phase shift mask can improve resolution and increase the margin of the exposure process.

For practical purposes, such phase shift masks can be broadly categorized, according to the light-transmitting characteristics of the phase shifter, as either completely transmitting phase shift masks or halftone phase shift masks. Completely transmitting phase shift masks are masks in which the phase shifter has the same light transmittance as the substrate, and which are thus transparent to light at the exposure wavelength. In halftone phase shift masks, the phase shifter has a light transmittance that ranges from about several percent to several tens of percent the transmittance of exposed substrate areas.

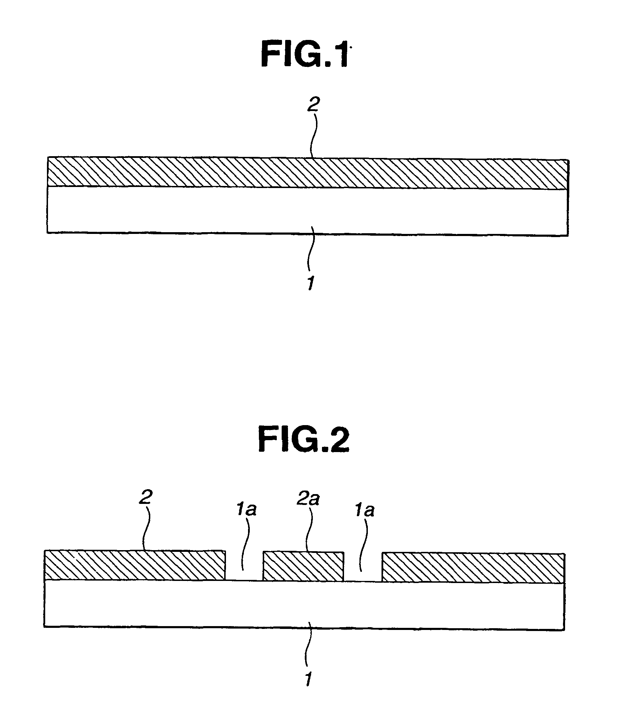

FIG. 1 shows the basic structure of a halftone phase shift mask blank, and FIG. 2 shows the basic structure of a halftone phase shift mask. The halftone phase shift mask blank shown in FIG. 1 is composed of a substrate 1 which is transparent to exposure light, and a halftone phase shift film 2 formed thereon. The halftone phase shift mask shown in FIG. 2 is composed of a halftone phase shifter 2a which forms the pattern areas of the mask, and exposed substrate areas 1a on which there is no phase shift film. The arrangement of the two types of areas defines the mask pattern.

Exposure light that has passed through the phase shifter 2a is phase-shifted relative to exposure light that has passed through exposed substrate areas 1a (see FIGS. 6A and 6B). The transmittance of the phase shifter 2a is selected such that exposure light which has passed through the phase shifter 2a has too low an intensity to sensitize the resist on the substrate to which the pattern is being transferred. Accordingly, the phase shifter 2a functions to substantially shield out exposure light.

Halftone phase shift masks of the above type include halftone phase shift masks having a simple, single-layer construction. Single-layer halftone phase shift masks known to the art include those described in JP-A 7-140635 which have a phase shifting film composed of molybdenum silicide oxide (MoSiO) or molybdenum silicide oxide nitride (MoSiON).

US 5 804 337 discloses a method of manufacturing a blank for a phase shift mask by sputtering a target comprising Mo and Si within an atmosphere of argon and N₂O gas to deposit a translucent phase shift film including Mo, O, N and Si onto a transparent substrate.

Such phase shift masks may be manufactured by using a lithographic process to pattern a phase shift mask blank. The lithographic process typically involves applying a resist onto the phase shift mask blank, sensitizing desired areas of the resist with an electron beam or ultraviolet light, carrying out development to expose the surface of the phase shift film, then etching desired areas of the phase shift film through the patterned resist film as the mask so as to expose the substrate. The resist film is then stripped, giving the finished phase shift mask.

In the above-described phase shift mask blanks and phase shift masks, if the phase shift film has a larger film stress than necessary, this may cause an originally flat substrate to warp after formation of the phase shift film, resulting in a loss of flatness in the phase shift mask blank. Moreover, when the phase shift film on the substrate that has warped owing to film stress is patterned by removal of selected areas thereof, the substrate warp changes because the film stress in those areas is released. Thus the substrate flatness differs before and after patterning.

Substrate warp may be pre-adjusted based on the anticipated stress in the phase shift film so as to improve flatness of the phase shift mask blank. However, the degree of film stress released by patterning is strongly affected by the pattern density and shape, and cannot be strictly determined. Thus, no matter how carefully the amount of warp is predicted, obtaining a flat phase shift mask is very difficult.

When a phase shift mask blank having such a high-stress phase shift film and a phase shift mask obtained by patterning such a blank are actually used to transfer a circuit pattern, warping of the mask causes it to deviate from the intended position designed for it within the exposure system, which results in shifting of the focal point. In addition, warping of the mask causes the position of the mask plane to vary, such as between the center of the substrate and the mask periphery. The optimal exposure conditions thus differ from region to region on the mask and focal shifts occur even within the plane of the exposure pattern, giving rise to non-uniformity in the plane of the pattern. The result is a poor exposure margin. It is thus difficult to stably manufacture phase shift masks of a high in-plane uniformity that are suitable for use in exposure processes. An improvement in this regard would be valuable in the industry.

A general aim herein is to provide new and useful phase shift masks, phase shift mask blanks and methods of making them. A preferred aim is to provide high-flatness, high-quality phase shift mask blanks and phase shift masks in which film stress in the phase shift film is reduced, allowing the respective changes in the amount of warp by the substrate following formation of the phase shift film relative to before formation and following patterning relative to before patterning to be minimized. Another object of the invention is to provide methods of manufacturing such phase shift mask blanks and phase shift masks.

It has been found that, in a phase shift mask blank having a transparent substrate and at least one phase shift film on the substrate, the use of a phase shift film composed of molybdenum silicide oxide carbide (MoSiOC) or molybdenum silicide oxide nitride carbide (MoSiONC), allows stress in the phase shift film to be reduced to not more than 100 MPa, thus avoiding a loss of substrate flatness when the phase shift film is formed and making it possible to obtain a phase shift mask blank and a phase shift mask of good flatness even after the phase shift film has been patterned.

Accordingly, in a first aspect, the invention provides a phase shift mask blank having a transparent substrate and at least one phase shift film on the substrate, wherein the phase shift film is made of molybdenum silicide oxide carbide or molybdenum silicide oxide nitride carbide and has a film stress of not more than 100 MPa.

Typically, the phase shift film changes the phase of exposure light passing through it by 180±5 degrees and has a transmittance of 3 to 40%.

In a second aspect, the invention provides a phase shift mask manufactured by lithographically patterning the phase shift mask blank of the first aspect of the invention.

In a third aspect, the invention provides a method of manufacturing a phase shift mask blank having a transparent substrate and at least one phase shift film on the substrate. Reactive sputtering is carried out using a sputtering target containing primarily molybdenum and silicon and using a carbon-containing sputtering gas so as to form a phase shift film having a film stress of not more than 100 MPa.

In the above phase shift mask blank manufacturing method, it is preferable for the resulting phase shift film to be made of molybdenum silicide oxide carbide or molybdenum silicide oxide nitride carbide. Reactive sputtering is typically carried out using carbon dioxide as the carbon-containing sputtering gas. Moreover, the phase shift film preferably changes the phase of exposure light passing through it by 180±5 degrees and has a transmittance of 3 to 40%.

In a fourth aspect, the invention provides a method of manufacturing a phase shift mask by lithographically patterning the phase shift mask blank made by the method according to the third aspect of the invention.

The invention reduces film stress in the phase shift film of halftone phase shift mask blanks and halftone phase shift masks to not more than 100 MPa. As a result, reductions can be achieved in both the change in the amount of warp by the substrate after formation of the phase shift film during phase shift mask blank production relative to before film formation, and the change in the amount of warp by the substrate after patterning of the phase shift film during phase shift mask production from a phase shift mask blank relative to before patterning. Such reductions make it possible to manufacture high-quality phase shift mask blanks and phase shift masks of a high flatness which, by enhancing the stability of the exposure process and allowing precise formation of the desired fine linewidth pattern, can be used to fabricate semiconductor integrated circuits to a smaller minimum feature-size and a higher level of integration.

### BRIEF DESCRIPTION OF THE DRAWINGS

The objects, features and advantages of the invention will become more apparent from the following detailed description, taken in conjunction with the accompanying drawings.
FIG. 1 is a sectional view of a phase shift mask blank according to one embodiment of the invention.
FIG. 2 is a sectional view of a phase shift mask made from the same blank.
FIG. 3 is a sectional view of a phase shift mask according to another embodiment of the invention.
FIG. 4 is a sectional view of the phase shift mask blank from which the phase shift mask in FIG. 3 is made.
FIGS. 5A to 5D are sectional views illustrating the method of manufacturing phase shift masks according to the invention. FIG. 5A shows a mask blank on which a resist film 13 has been formed, FIG. 5B shows the mask workpiece after the resist film 13 has been patterned, FIG. 5C shows the workpiece after etching has been carried out, and FIG. 5D shows the completed mask after the resist film 13 has been removed.
FIGS. 6A and B illustrate the operating principle of a halftone phase shift mask. FIG. 6B is an enlarged view of region X in FIG. 6A.

### DETAILED DESCRIPTION

Referring to FIG. 1, the phase shift mask blank of the invention is made up of a substrate 1 which is transparent to exposure light and a phase shift film 2 formed on the substrate 1. The phase shift film 2 has a film stress of not more than 100 MPa. The reduced film stress minimizes both the change in the amount of warp by the substrate after formation of the phase shift film during phase shift mask blank production, as opposed to before film formation, and the change in the amount of warp by the substrate after patterning of the phase shift film during phase shift mask production, as opposed to before patterning. This makes it possible to obtain a phase shift mask blank and a phase shift mask which are both of high quality and have a high degree of flatness.

Conceivable approaches for setting the stress in the phase shift film at not more than 100 MPa, and preferably not more than 80 MPa, include adjustment of the phase shift film formation conditions and adjustment of the phase shift film composition. However, altering the film forming conditions is not a desirable course of action because the optical properties of the phase shift film are strongly affected by the film forming conditions. Thus, in the practice of the invention, the film stress is reduced without a loss in the optical characteristics by adding elements capable of lowering film stress and thus optimizing the film composition.

Specifically, the phase shift film is made of molybdenum silicide oxide carbide (MoSiOC) or molybdenum silicide oxide nitride carbide (MoSiONC). To set the stress of the phase shift film at not more than 100 MPa, and preferably not more than 80 MPa, a molybdenum silicide oxide carbide (MoSiOC) film having a composition of 5 to 25 atom % molybdenum, 10 to 35 atom % silicon, 30 to 60 atom % oxygen and 3 to 20 atom % carbon, or a molybdenum silicide oxide nitride carbide (MoSiONC) film having a composition of 5 to 25 atom % molybdenum, 10 to 35 atom % silicon, 30 to 60 atom % oxygen, 5 to 30 atom % nitrogen and 3 to 20 atom % carbon, is preferred.

It is advantageous for the phase shift film to change the phase of exposure light passing through it by 180±5 degrees and to have a transmittance of 3 to 40%. Preferably, the transparent substrate used together with the phase shift film is composed primarily of quartz or silicon dioxide.

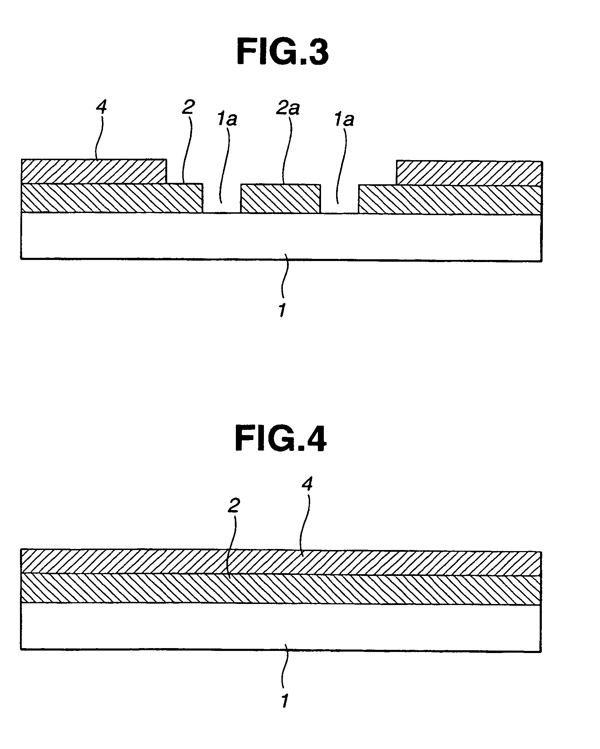

In the practice of the invention, the phase shift film is not necessarily limited to a single layer. For example, as shown in FIGS. 3 and 4, the phase shift mask and the phase shift mask blank of the invention may include a light-shielding film 4 that is formed over the phase shift film 2. The use of a chromium-based film (e.g., CrO, CrN, CrON, or CrCON) as the light-shielding film is preferred.

The phase shift film in the manufacturing method of the invention is formed by reactive sputtering. A sputtering target composed primarily of molybdenum and silicon is used. The target may be composed entirely of molybdenum and silicon, although a target in which one or more elements selected from among oxygen, nitrogen and carbon is added to the molybdenum may be used to keep the film composition constant within the plane of the film.

The sputtering process may be one which employs a direct-current power supply (DC sputtering) or a highfrequency power supply (RF sputtering). Either a magnetron sputtering system or a conventional sputtering system may be used. The film-forming system may be either a continuous, in-line system or a single-workpiece processing system.

To obtain a phase shift film having the desired composition and film stress, the sputtering gas used during formation of the phase shift film may be composed of an inert gas such as argon to which are suitably added oxygen, nitrogen, a nitrogen oxide gas, and a carbon-containing gas such as a carbon oxide gas. Exemplary carbon-containing gases include hydrocarbon gases such as methane, and carbon oxide gases carbon monoxide and carbon dioxide. The use of carbon dioxide is especially preferred because, in addition to serving as both a carbon source and an oxygen source, it is a stable gas having a low reactivity.

The sputtering gas used to form a MoSiOC or MoSiONC film is preferably a mixture of an inert gas such as argon and a carbon-containing gas. Other gases such as oxygen, nitrogen and nitrogen oxide gases may be suitably added so as to give the phase shift film that is formed the desired composition and film stress.

More specifically, formation of a MoSiOC film is preferably carried out by reactive sputtering using molybdenum silicide as the sputtering target and using a sputtering gas which contains argon and carbon dioxide gases. Formation of a MoSiONC film is preferably carried out by reactive sputtering using molybdenum silicide as the target and using a sputtering gas which contains argon, carbon dioxide and nitrogen gases.

The transmittance of the phase shift film being formed may be raised by increasing the amount of oxygen and nitrogen-containing gases added to the sputtering gas, or by using as the sputtering target a molybdenum silicide to which a large amount of oxygen and nitrogen have been added, so as to incorporate more oxygen and nitrogen into the film.

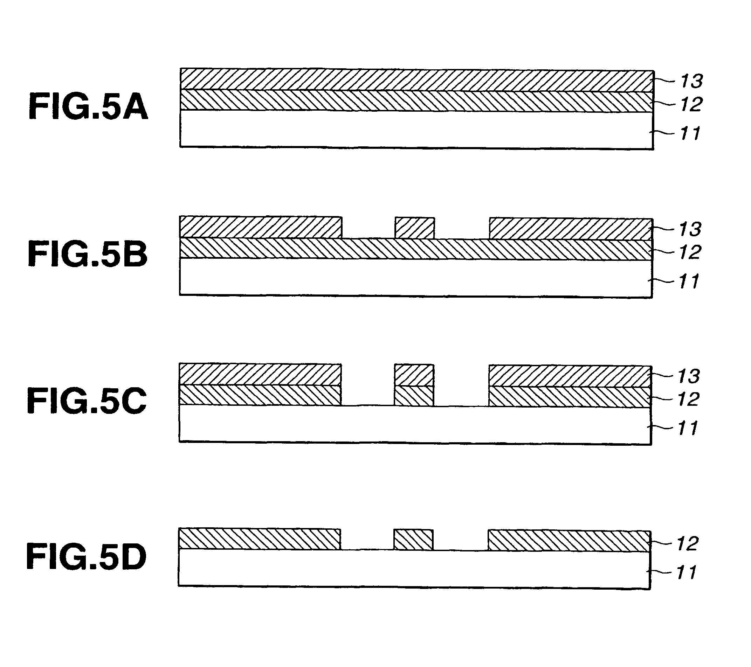

Using a phase shift mask blank according to the invention, a phase shift mask as shown in FIG. 2 may be manufactured as follows. After a phase shift film 12 is formed on a transparent substrate 11, a resist film 13 is formed on the phase shift film 12 (FIG. 5A). Next, the resist film 13 is patterned (FIG. 5B), after which the phase shift film 12 is dry etched or wet etched (FIG. 5C). The resist film 13 is subsequently stripped (FIG. 5D). In this process, application of the resist film, patterning (exposure and development), resist film removal, and etching may be carried out by known techniques.

In the resulting phase shift mask of the invention, the phase shift film has a small film stress. As a result, the change in the amount of warp by the substrate after patterning of the film relative to before patterning is small, making it possible to produce a mask having a high degree of flatness. This in turn stabilizes the exposure process, making it highly effective for the fabrication of semiconductor integrated circuits to a smaller minimum feature size and a higher level of integration.

### EXAMPLE

The following example and comparative example are provided by way of illustration, and are not intended to limit the scope of the invention.

### Example 1

A MoSiONC film was formed on a quartz substrate to a thickness of 140 nm by carrying out reactive sputtering in a sputtering system using molybdenum silicide as the sputtering target and using a mixture of argon, carbon dioxide and nitrogen as the sputtering gas.

The optical properties for 248 nm light, specifically the phase shift difference and transmittance, of the resulting sample were measured. The phase shift film was found to provide a phase shift of 182 degrees and a transmittance of 8.3%. The composition of this sample film, as determined by x-ray photoelectron spectroscopy (XPS), was 14 atom % molybdenum, 23 atom % silicon, 46 atom % oxygen, 10 atom % nitrogen, and 8 atom % carbon.

The change in flatness following formation of the MoSiONC film, relative to before film formation, within a 144 × 144 mm square on the 152 × 152 × 6.35 mm substrate obtained, was measured with an FT-900 flatness tester (manufactured by Nidek Co., Ltd.). The value was 0.38 µm. The film stress at this time was calculated to be 77 MPa, and the direction of stress was compressive. The results are shown in Table 1.

### comparative Example 1

Aside from using oxygen gas instead of carbon dioxide, a MoSiON film was formed to a thickness of 130 nm on a quartz substrate in the same way as in Example 1, giving a phase shift film which provided a phase shift of 182 degrees and a transmittance of 7.0% at 248 nm. The composition of this sample film, as determined by XPS, was 13 atom % molybdenum, 26 atom % silicon, 47 atom % oxygen, and 14 atom % nitrogen. The level of carbon was below the limit of detection.

The change in flatness following formation of the MoSiON film, relative to before film formation, within a 144 × 144 mm square on the 152 × 152 × 6.35 mm substrate obtained, was measured as in Example 1. The value obtained was 0.59 µm. The film stress at this time was calculated to be 125 MPa, and the direction of stress was compressive. The results are shown in Table 1.

**Table 1**

| | Phase shift film | Change in flatness | Film stress |
|---|---|---|---|
| Example 1 | MoSiONC | 0.38 µm | 77 MPa |
| Comparative Example 1 | MoSiON | 0.59 µm | 125 MPa |

From the results in Table 1, it is apparent that the MoSiONC film in Example 1 had a smaller film stress than the MoSiON film in Comparative Example 1, thus enabling the loss of substrate flatness to be reduced and also making it possible to decrease the change in flatness after patterning relative to before patterning.

Therefore, the present invention, by having the phase shift film made of molybdenum silicide oxide carbide or molybdenum silicide oxide nitride carbide, is able to reduce the stress in the phase shift film to not more than 100 MPa. In this way the invention provides both high-quality phase shift mask blanks in which the flatness of the substrate is not diminished during formation of the phase shift layer on the substrate, and high-quality phase shift masks which retain a good flatness even after the phase shift film on the blank has been patterned.

Although some preferred embodiments have been described, many modifications and variations may be made thereto in light of the above teachings. It is therefore to be understood that the invention may be practiced otherwise than as specifically described in the Examples.

## Claims

1. A phase shift mask blank comprising a transparent substrate and at least one phase shift film on the substrate, wherein the phase shift film is made of molybdenum silicide oxide carbide or molybdenum silicide oxide nitride carbide and has a film stress of not more than 100 MPa.

2. A phase shift mask blank according to claim 1, wherein the phase shift film contains from 3 to 20 atom% of carbon.

3. A phase shift mask blank according to claim 1 in which the phase shift film is of a molybdenum silicide oxide carbide film containing 5 to 25 atom% Mo, 10 to 35 atom% Si, 30 to 60 atom% 0 and 3 to 20 atom% C, or of a molybdenum silicide oxide nitride carbide containing 5 to 25 atom% Mo, 10 to 35 atom% Si, 30 to 60 atom% O, 5 to 30 atom% N and 3 to 20 atom% C.

4. A phase shift mask blank according to any one of claims 1 to 3 having a chromium-based light shielding film formed over said phase shift film.

5. A phase shift mask blank according to any one of the preceding claims in which the substrate is composed primarily of quartz or silicon dioxide.

6. A phase shift mask blank according to any one of the preceding claims in which said film stress in the phase shift film is not more than 80 MPa.

7. A phase shift mask blank according to any one of the preceding claims, wherein the phase shift film changes the phase of exposure light passing through it by 180±5 degrees and has a transmittance of 3 to 40%.

8. A phase shift mask manufactured by lithographically patterning a phase shift mask blank according to any one of claims 1 to 7.

9. A method of manufacturing a phase shift mask blank having a transparent substrate and at least one phase shift film on the substrate, the method comprising the step of carrying out reactive sputtering using a sputtering target containing primarily molybdenum and silicon and using a carbon-containing sputtering gas, so as to form a phase shift film having a film stress of not more than 100 MPa.

10. A phase shift mask blank manufacturing method according to claim 9, wherein the reactive sputtering is carried out using carbon dioxide as the carbon-containing sputtering gas.

11. A phase shift mask blank manufacturing method according to claim 9 or 10 wherein the phase shift film formed is of molybdenum silicide oxide carbide or molybdenum silicide oxide nitride carbide.

12. A phase shift mask blank manufacturing method according to claim 11 in which the resulting blank accords with any one of claims 2 to 7.

13. A method of manufacturing a phase shift mask by lithographically patterning a phase shift mask blank made by a method according to any one of claims 9 to 12.

## Patentansprüche

1. Phasenverschiebungsmaskenrohling, umfassend ein transparentes Substrat und zumindest einen Phasenverschiebungsfilm auf dem Substrat, worin der Phasenverschiebungsfilm aus Molybdänsilicidoxidcarbid oder Molybdänsilicidoxidnitridcarbid besteht und eine Filmspannung von nicht mehr als 100 MPa aufweist.

2. Phasenverschiebungsmaskenrohling nach Anspruch 1, worin der Phasenverschiebungsfilm 3 bis 20 Atom-% Kohlenstoff enthält.

3. Phasenverschiebungsmaskenrohling nach Anspruch 1, worin der Phasenverschiebungsfilm aus einem Molybdänsilicidoxidcarbid-Film besteht, der 5 bis 25 Atom-% Mo, 10 bis 35 Atom-% Si, 30 bis 60 Atom-% 0 und 3 bis 20 Atom-% C enthält, oder aus einem Molybdänsilicidoxidnitridcarbid-Film, der 5 bis 25 Atom-% Mo, 10 bis 35 Atom-% Si, 30 bis 60 Atom-% 0, 5 bis 30 Atom-% N und 3 bis 20 Atom-% C enthält.

4. Phasenverschiebungsmaskenrohling nach einem der Ansprüche 1 bis 3, worin ein lichtabschirmender Film auf Chrombasis auf dem Phasenverschiebungsfilm ausgebildet ist.

5. Phasenverschiebungsmaskenrohling nach einem der vorangegangenen Ansprüche, worin das Substrat hauptsächlich aus Quarz oder Siliciumdioxid besteht.

6. Phasenverschiebungsmaskenrohling nach einem der vorangegangenen Ansprüche, worin die Filmspannung im Phasenverschiebungsfilm nicht mehr als 80 MPa beträgt.

7. Phasenverschiebungsmaskenrohling nach einem der vorangegangenen Ansprüche, worin der Phasenverschiebungsfilm die Phase von Bestrahlungslicht, das durch ihn hindurchgeht, um 180 ± 5° verschiebt und eine Durchlässigkeit von 3 bis 40 % aufweist.

8. Phasenverschiebungsmaske, die durch lithographische Strukturierung eines Phasenverschiebungsmaskenrohlings nach einem der Ansprüche 1 bis 7 hergestellt ist.

9. Verfahren zur Herstellung eines Phasenverschiebungsmaskenrohlings mit einem transparenten Substrat und zumindest einem Phasenverschiebungsfilm auf dem Substrat, wobei das Verfahren den Schritt der Durchführung von reaktivem Sputtern unter Verwendung eines hauptsächlich Molybdän und Silicium enthaltenden Sputtertargets und eines kohlenstoffhältigen Sputtergases umfasst, um einen Phasenverschiebungsfilm mit einer Filmspannung von nicht mehr als 100 MPa auszubilden.

10. Phasenverschiebungsmaskenrohlings-Herstellungsverfahren nach Anspruch 9, worin das reaktive Sputtern unter Verwendung von Kohlendioxid als kohlenstoffhältiges Sputtergas durchgeführt wird.

11. Phasenverschiebungsmaskenrohlings-Herstellungsverfahren nach Anspruch 9 oder 10, worin der Phasenverschiebungsfilm aus Molybdänsilicidoxidcarbid oder Molybdänsilicidoxidnitridcarbid besteht.

12. Phasenverschiebungsmaskenrohlings-Herstellungsverfahren nach Anspruch 11, worin der resultierende Rohling einem der Ansprüche 2 bis 7 entspricht.

13. Verfahren zur Herstellung einer Phasenverschiebungsmaske durch lithographische Strukturierung eines durch ein Verfahren nach einem der Ansprüche 9 bis 12 hergestellten Phasenverschiebungsmaskenrohlings.

## Revendications

1. Une ébauche de masque à décalage de phase comprenant un substrat transparent et au moins un film à décalage de phase sur le substrat, dans lequel le film à décalage de phase est réalisé en carbure d'oxyde de siliciure de molybdène ou en carbure de nitrure d'oxyde de siliciure de molybdène et présente une contrainte de film pas supérieure à 100 MPa.

2. Une ébauche de masque à décalage de phase selon la revendication 1, dans lequel le film à décalage de phase contient de 3 à 20% atomique de carbone.

3. Une ébauche de masque à décalage de phase selon la revendication 1, dans lequel le film à décalage de phase est formé d'un film de carbure d'oxyde de siliciure de molybdène contenant de 5 à 25% atomique de Mo, 10 à 35% atomique de Si, 30 à 60% atomique de 0 et 3 à 20% atomique de C, ou d'un carbure de nitrure d'oxyde de siliciure de molybdène contenant de 5 à 25% atomique de Mo, 10 à 35% atomique de Si, 30 à 60% atomique de 0, 5 à 30% atomique de N et 3 à 20% atomique de C.

4. Une ébauche de masque à décalage de phase selon l'une quelconque des revendications 1 à 3, comprenant un film de protection contre la lumière à base de chrome formée sur ledit film à décalage de phase.

5. Une ébauche de masque à décalage de phase selon l'une quelconque des revendications précédentes, dans laquelle le substrat est composé principalement de quartz ou dioxyde de silicium.

6. Une ébauche de masque à décalage de phase selon l'une quelconque des revendications précédentes, dans lequel ladite contrainte de film du film à décalage de phase n'est pas supérieure à 80 MPa.

7. Une ébauche de masque à décalage de phase selon l'une quelconque des revendications précédentes, dans lequel le film à décalage de phase change, de 180±5 degrés, la phase de la lumière d'exposition passant à travers lui, et présente un facteur de transmission de 3 à 40%.

8. Un masque à décalage de phase fabriqué en modélisant de manière lithographique une ébauche de masque à décalage de phase selon l'une quelconque des revendications 1 à 7.

9. Un procédé de fabrication d'une ébauche de masque à décalage de phase comprenant un substrat transparent et au moins un film à décalage de phase sur le substrat, le procédé comprenant l'étape consistant à mettre en oeuvre une pulvérisation réactive utilisant une cible de pulvérisation contenant principalement du molybdène et du silicium et utilisant un gaz de pulvérisation contenant du carbone, de manière à former un film à décalage de phase ayant une contrainte de film pas supérieure à 100 MPa.

10. Un procédé de fabrication d'une ébauche de masque à décalage de phase selon la revendication 9, dans lequel la pulvérisation réactive est mise en oeuvre en utilisant du dioxyde de carbone en tant que gaz de pulvérisation contenant du carbone.

11. Un procédé de fabrication d'une ébauche de masque à décalage de phase selon la revendication 9 ou 10, dans lequel le film à décalage de phase est formé de carbure d'oxyde de siliciure de molybdène ou de carbure de nitrure d'oxyde de siliciure de molybdène.

12. Un procédé de fabrication d'une ébauche de masque à décalage de phase selon la revendication 11, dans lequel l'ébauche résultante est conforme à l'une quelconque des revendications 2 à 7.

13. Un procédé de fabrication d'un masque à décalage de phase en modélisant de manière lithographique une ébauche de masque à décalage de phase réalisée par le procédé selon l'une quelconque des revendications 9 à 12.
